# EUROPÄISCHE PATENTSCHRIFT

(11) **EP 1 881 368 B1**
(45) Veröffentlichungstag und Bekanntmachung des Hinweises auf die Patenterteilung: **13.06.2012**
(21) Anmeldenummer: 07012255.1
(22) Anmeldetag: 22.06.2007
(51) Int. Cl.: B82Y 10/00, G03F 7/00, B82B 3/00

(54) **Verfahren zum Aufbringen von Membranlipiden auf ein Substrat**
Method for applying membrane lipids to a substrate
Procédé destiné à l'application de lipides membranaires sur un substrat

(30) Priorität: 19.07.2006 DE 102006033332
(43) Veröffentlichungstag der Anmeldung: 23.01.2008
(73) Patentinhaber: Karlsruher Institut für Technologie, 76131 Karlsruhe (DE)
(72) Erfinder: Lenhert, Steven, 48149 Münster (DE); Fuchs, Harald, 48301 Nottuln (DE)

(56) Entgegenhaltungen:
- WO-A-00/41213
- KR-A- 20040 094 982
- US-A1- 2006 242 740
- J. NISSEN ET AL: "Interface Dynamics of Lipid Membrane Spreading on Solid Surfaces" PHYSICAL REVIEW LETTER, Bd. 86, Nr. 9, 26. Februar 2001 (2001-02-26), Seiten 1904-1907, XP002492491
- SU MING ET AL: "Colored ink dip-pen nanolithography" APPLIED PHYSICS LETTERS, AIP, AMERICAN INSTITUTE OF PHYSICS, MELVILLE, NY, Bd. 80, Nr. 23, 10. Juni 2002 (2002-06-10), Seiten 4434-4436, XP012031167 ISSN: 0003-6951
- P. MORAILLE ET AL: "Nanoscale Stripe Patterns in Phospholipid Bilayers Formed by the Langmuir-Blodgett Technique" LANGMUIR, Bd. 19, 16. September 2003 (2003-09-16), Seiten 8041-8049, XP002492492
- CARLSON J W ET AL: "Nanopatterning Phospholipid bilayers", LANGMUIR: THE ACS JOURNAL OF SURFACES AND COLLOIDS, AMERICAN CHEMICAL SOCIETY, WASHINGTON, DC, USA, vol. 16, 17 March 2000 (2000-03-17), pages 3927-3931, XP002304650, ISSN: 0743-7463, DOI: DOI:10.1021/LA990860X

## Beschreibung

Die Erfindung betrifft ein Verfahren zum Aufbringen einer oder mehrerer, übereinander aufgebrachter Doppelschichten von Membranlipiden auf ein Substrat.

Membranlipide sind amphiphathische Moleküle (amphiphile Moleküle), d.h. sie verfügen über einen hydrophilen Anteil (polare Kopfregion) und einen hydrophoben Anteil (lange Kohlenwasserstoffketten). Bekannt sind drei Hauptgruppen von Membranlipiden, d.h. Phospholipide, Glykolipide und Cholesterin, sowie die Nebengruppe Etherlipide, die verzweigte Ketten aufweist.

Phospholipide bestehen aus vier chemischen Komponenten: Fettsäuren, einer chemischen Plattform, an der die Fettsäuren gebunden sind, einer Phosphatgruppe und einer an die Phosphatgruppe als Ester gebundenen Alkohol. Die chemische Plattform ist entweder Glycerin oder Sphingosin-Aminoalkohol. Die Fettsäuren variieren in der Länge, dem Sättigungsgrad und dem Verzweigungsgrad ihrer Kohlenwasserstoffkette.

Die WO 00/41213 A1 und die US 2002/0122873 A1 offenbaren *Dip Pen Nanolithography* (DPN) als lithographisches Verfahren zur Herstellung von Strukturen mit Abmessungen von 10-1000 nm mittels eines Rasterkraftmikroskops *(Atomic Force Microscope,* AFM). Hierbei wird die Spitze des Rasterkraftmikroskops mit der so genannten *Tinte* benetzt, die durch eine treibende Kraft auf die Oberfläche eines Substrats übertragen wird. Das makroskopische Analogon der DPN ist das Schreiben mit Feder und Tusche, wobei hier die Feder einen Krümmungsradius im Nanomaßstab aufweist. Aufgrund der Luftfeuchtigkeit bildet sich zwischen der Spitze und der Oberfläche eines Substrats ein wässriger Meniskus aus, der dem Transfer der Moleküle von der Spitze auf die Oberfläche dient. Dort werden diese Moleküle chemisch absorbiert oder ordnen sich auf entsprechend präparierten Oberflächen an. Als treibende Kräfte dienen chemische, elektrische oder magnetische Kräfte, um Moleküle, Cluster oder Nanokristalle auf das Substrat aufzubringen. Bisher lassen sich hiermit lediglich die lateralen Dimensionen der auf der Oberfläche aufgebrachten Strukturen einstellen.

Aus der US 6,756,078 B2 ist ein Verfahren zum Aufbringen von Phospholipiden auf ein Substrat bekannt, bei dem das Substrat, das mit einer Monolage aus einem Thioalkyl als reaktiver Substanz beschichtet ist, zunächst mit einem Linker in Kontakt gebracht wird, wodurch sich der Linker mit der reaktiven Substanz zu einer derivatisierten Monolage verbindet. Erst hierauf werden anschließend die Phospholipide, die mit dem Linker eine chemische Verbindung eingehen, aufgebracht. Die erforderliche kovalente chemische Bindung zwischen den Phospholipiden und dem Substrat ist insofern nachteilig, da diese die laterale Mobilität innerhalb der Lipid-Doppelschicht begrenzt.

Die US 2002/0009807 A1 offenbart ein Verfahren zum Aufbringen von Phospholipiden auf Bereiche eines Substrats, die mit einer Schicht versehen worden sind, die das Aufbringen von Lipid-Doppelschichten begünstigt. Hierbei wird eine wässrige Phase, die die Phospholipide enthält, auf das Substrat aufgebracht.

Aus J.W. Carlson, T. Bayburt und S.G. Sligar, Nanopatterning Phospholipid Bilayers, Langmuir 2000, 16, 3927-3931, ist ein Verfahren zum Strukturieren von Phospholipiden auf einem Substrat bekannt, wobei Bereiche der Schicht aus Phospholipiden auf der Oberfläche des Substrats mit der Spitze eines Rasterkraftmikroskops entfernt werden. Hierbei muss darauf geachtet werden, dass die Schicht aus Phospholipiden nicht austrocknet.

Aus S. Tristram-Nagle, H. I. Petrache und J. F. Nagle, Structure and interactions of fully hydrated dioleoylphosphatidylcholine bilayers, Biophys. J. 75, 917-925 (1998), und S. Schuy und A. Janshoff, Thermal expansion of microstructured DMPC bilayers quantified by temperature controlled atomic force microscopy, Chembiochem 7, 1207-1210 (2006) ist bekannt, dass 1,2-Dioleoyl-sn-Glycero-3-Phosphocholin (DOPC) bei 20 °C als flüssigkristalline Phase vorliegt und dass die Dicke einer Lipid-Doppelschicht bei 3,4 bis 3,5 nm liegt, wobei der genaue Wert von der Temperatur, dem Luftdruck und der Luftfeuchtigkeit abhängt.

In J. Nissen, K. Jacobs und J. O. Rädler, Interface Dynamica of Lipid Membrane Spreading on Solid Surfaces, Phys. Rew. Lett. 86, S. 1904-1907, 2001, wird die Dynamik der Ausbreitung von Membranlipiden auf einer ebenen Oberfläche am Beispiel der Phospholipide theoretisch und experimentell untersucht.

Ausgehend hiervon ist es die Aufgabe der vorliegenden Erfindung, ein Verfahren zum Aufbringen einer oder mehrerer, übereinander aufgebrachter Doppelschichten von Membranlipiden auf ein Substrat vorzuschlagen, das die vorher genannten Nachteile und Einschränkungen nicht aufweist.

Insbesondere soll ein Verfahren bereitgestellt werden, das das Aufbringen einer oder mehrerer, übereinander aufgebrachter Doppelschichten von Membranlipiden auf ein Substrat ermöglicht, ohne dass das Substrat einer vorherigen chemischen Behandlung unterzogen werden muss.

Weiterhin sollen die Membranlipide auf das Substrat aufgebracht werden, ohne dass sie mit dem Substrat selbst oder über hierauf weiter aufbrachten Substanzen chemisch gebunden sind.

Schließlich soll es dieses Verfahren ermöglichen, die Anzahl der aufgebrachten Lipidschichten oder Lipid-Doppelschichten auf dem Substrat einfach einzustellen.

Diese Aufgaben werden durch die Verfahrensschritte des Anspruchs 1 gelöst. Die Unteransprüche beschreiben vorteilhafte Ausgestaltungen der Erfindung.

Zur Durchführung des erfindungsgemäßen Verfahrens zum Aufbringen einer oder mehrerer Doppelschichten aus Membranlipiden wird zunächst gemäß Verfahrensschritt a) ein Substrat bereitgestellt.

Als Substrat eignet sich eine große Vielfalt an Oberflächen, bevorzugt ausgehend von hydrophilem Silizium über Glas und Metall bis hin zu hydrophoben Polymeren wie z. B. Polystyrol. Die Substrate sind entweder unbehandelt oder werden in einer besonderen Ausgestaltung zuvor einer hydrophilen Behandlung mit einem Sauerstoffplasma unterzogen oder in bevorzugten Bereichen mittels Lithographie behandelt.

Unabhängig hiervon werden gemäß Verfahrensschritt b) Membranlipide auf die Spitze eines Rasterkraftmikroskops aufgebracht. Hierzu wird die Spitze des Rasterkraftmikroskops derart in eine Tinte aus Membranlipiden eingetaucht, dass sie hiervon benetzt wird. Während Verfahrensschritt a) wurde der Tintenvorrat mit einer Lösung eines Membranlipids in einem unpolaren Lösungsmittel aufgefüllt und darüber hinaus ggf. ein Farbstoff zur Lösung hinzugefügt. Die Lösung wurde stehengelassen, bis das Lösungsmittel weitgehend verdampft war, bevor die Spitze des Rasterkraftmikroskops durch Eintauchen in den Tintenvorrat, der die Membranlipide enthält, reversibel mit den Membranlipiden benetzt wird. Aufgrund der amphiphathischen Eigenschaften der Membranlipide ist es möglich, Physisorption als treibende Kraft für den Transport der Membranlipide aus der Tinte auf die Spitze einzusetzen. Auf diese Weise lässt sich die Spitze des Rasterkraftmikroskops reproduzierbar benetzen.

Hieran anschließend wird gemäß Verfahrensschritt c) die Spitze des Rasterkraftmikroskops mit der Oberfläche des Substrats in Kontakt gebracht, wobei die Oberfläche direkt berührt wird. Aufgrund der Luftfeuchtigkeit der Atmosphäre, die mindestens 40 %, bevorzugt mindestens 70 % beträgt, bildet sich zwischen der Spitze und der Oberfläche des Substrats ein wässriger Meniskus aus, wodurch die Membranlipide beginnen, von der Spitze auf die Oberfläche zu wandern. Wird die Spitze des Rasterkraftmikroskops nun mit einer bestimmten Geschwindigkeit über ausgewählte Bereiche auf der Oberfläche geführt, ordnen sich die Membranlipide in diesen Bereichen auf der Oberfläche in Form von einer oder mehreren, übereinander aufgebrachten Lipid-Doppelschichten als flüssigkristalline Phase an.

Entscheidend ist hierbei, dass die Membranlipide so auf das Substrat aufgebracht werden, ohne dass sie direkt mit dem Substrat oder über auf dem Substrat aufgebrachte Substanzen indirekt chemisch kovalent an das Substrat gebunden sind.

Die vorliegende Erfindung macht Gebrauch von der dreidimensionalen Selbstorganisation der Membranlipide, insbesondere der Phospholipide, als treibender Kraft für die Strukturbildung.

Diese treibende Kraft ist einzigartig für lyotrope flüssigkristalline Materialien, bevorzugt für Phospholipide 1,2-Dioleoyl-sn-Glycero-3-Phosphocholin (DOPC) bei 20°C und 1,2-Dimyristoyl-sn-Glycero-3-Phosphöcholin (DMPC) bei 35°C, die teilweise mit einem Fluoreszenzmarker versehen sein können.

In einer besonders bevorzugten Ausführungsform wird die Anzahl der Lipid- Doppelschichten auf der Oberfläche über die Geschwindigkeit, mit der sich die Spitze des Rasterkraftmikroskops über die Oberfläche des Substrats bewegt, sowie über den Wert der relativen Luftfeuchtigkeit eingestellt.

Es ist bekannt, dass das Phasenverhalten der Phospholipide empfindlich für Hydratation ist, die sich über die relative Luftfeuchtigkeit einstellen lässt. Über den Wert der relativen Luftfeuchtigkeit lässt sich damit die Rate, mit der sich die Membranlipide von der Spitze des Rasterkraftmikroskops auf die Oberfläche des Substrats bewegen, einstellen. Damit erlaubt das erfindungsgemäße Verfahren, den dreidimensionalen Aufbau der Lipid - Doppelschichten auf der Oberfläche des Substrats mit der Präzision einer einzelnen Schicht einzustellen. Schließlich wird gemäß Verfahrensschritt d) die Spitze von der Oberfläche des Substrats entfernt.

Phospholipide wurde erfindungsgemäß als Tinte für die nichtkovalente Strukturierung von unterschiedlichen Oberflächen eingesetzt. Die laterale Auflösung der bisher auf diese Weise erhaltenen Strukturen betrug 50 nm bis 100 nm.

Die Einstellung der Viskosität der Tinte aus Phospoholipiden ermöglicht es, die Tinte ausschließlich auf der Spitze des Rasterkraftmikroskops abzulagern und somit eine Immersion des gesamten Cantilevers bzw. des Substrats in der Lösung zu vermeiden und damit gleichzeitig das Risiko der Querkontamierung im Vergleich zum Arbeiten in Lösungen zu verringern.

Da das vorliegende Verfahren auch auf trockenen Oberflächen funktioniert, muss auch nicht auf ein etwaiges nachteiliges Austrocknen der Spitze des Rasterkraftmikroskops oder des Substrats geachtet werden.

Da die Strukturierung nicht auf eine bereits auf dem Substrat vorhandene Schicht aus Phospholipiden angewiesen ist, erfolgt die Strukturierung unabhängig von der Kontaktkraft zwischen der Spitze des Rasterkraftmikroskops und dem Substrat und kann daher ohne Feedback Kontrolle des Rasterkraftmikroskops ausgeführt werden. Diese Eigenschaft ist in der Praxis Voraussetzung für gleichzeitiges Schreiben mit mehreren Spitzen.

Gleichzeitiges Schreiben mit verschiedenen Tinten ermöglicht die präzise Anordnung und Ausbringung von chemisch unterschiedenen Membranlipid-Strukturen auf einem Substrat.

Die Erfindung wird im Folgenden anhand von Ausführungsbeispielen näher erläutert. Die Figuren zeigen im Einzelnen:
- **Fig. 1**: Schematische Darstellung des Verfahrens (Querschnitt)
- **Fig. 2**: Höhe der Phospholipid-Schichten (links) und der Anzahl der Lipid-Doppelschichten (rechts) als Funktion der der Geschwindigkeit des Aufbringens der einer Phospholipid- schicht bei 70 % bzw. 45 % relativer Luftfeuchtigkeit

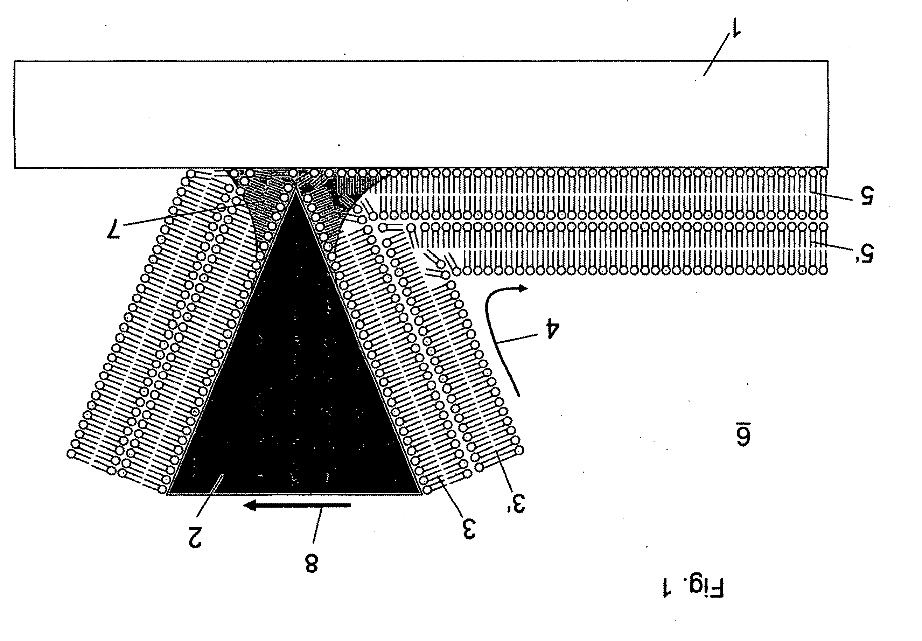

**Figur 1** zeigt schematisch die Funktionsweise des erfindungsgemäßen Verfahrens. Dip Pen Nanolithography wurde mittels eines kommerziell erhältlichen DPN Schreibers ausgeführt. Hierzu wurde der Tintenvorrat mit 1 µl einer 10 mM Lösung eines Phospholipids in einem unpolaren Lösungsmittel wie Chloroform oder Dichlormethan aufgefüllt. In einigen Versuchen wurden darüber hinaus 1 Mol% eines Farbstoffs zur Lösung hinzugefügt.

Als Phospholipid wurden zum einen 1,2-Dioleoyl-sn-Glycero-3-Phosphocholin (DOPC) oder 1,2-Dimyristoyl-sn-Glycero-3-Phosphocholin (DMPC) und zum anderen mit 1 % Fluoreszenzmarker versehene Phospholipide 1,2-Dioleoyl-sn-Glycero-3-Phosphoethanolamin-N-(Lissamin Rhodamin B Sulfonyl) (18:1 Lissamin Rhodamin PE) oder 1,2-Dioleoyl-sn-Glycero-3-Phosphoethanolamin-N-(7-nitro-2-1,3-benzoxadiazol-4-yl) (18:1 NBD PE) eingesetzt.

Die Lösung wurde stehengelassen, bis das Lösungsmittel weitgehend verdampft war, bevor die Spitze **2** des Rasterkraftmikroskops (AFM) durch Eintauchen in den Tintenvorrat, der die Phospholipide enthielt, reversibel mit den Phospholipiden **3, 3'** benetzt wurde. Die relative Luftfeuchtigkeit wurde über einen Zeitraum von mind. 30 Minuten auf mind. 50 %, bevorzugt mind. 60 %, besonders bevorzugt mind. 90 % erhöht, da erst bei hoher Luftfeuchtigkeit die Phospholipide ausreichend flüssig sind, um die Spitze umgehend zu benetzen. Bei einer relativen Luftfeuchtigkeit unterhalb von 50 % floss die Tinte nicht mehr aus dem Tintenvorrat auf die Spitze **2**.

Mit dem erfindungsgemäßen Verfahren wurden dann in Schreibrichtung **8** Strukturen **5**, **5'** aus DOPC auf einem Substrat 1 aus Silizium, Glas, einem 100 nm dicken Titanfilm oder dem Polymer Polystyrol aufgebracht. Aufgrund der Luftfeuchtigkeit der Atmosphäre **6** bildete sich zwischen der Spitze **2** des Rasterkraftmikroskops und der Oberfläche des Substrats **1** ein wässriger Meniskus **7** aus, der dem Transfer **4** der Moleküle von der Spitze **2** auf die Oberfläche diente.

Während sich nach dem bekannten Stand der Technik kovalent auf dem Substrat gebundene Tinten als Monolage über die Oberfläche ausbreiten, bilden erfindungsgemäß auf dem Substrat **1** aufgebrachte Phospholipide eine oder mehrere, übereinander angeordnete Schichten **5,5',** deren Höhe von der Geschwindigkeit des Aufbringens mit der Spitze **2** in Schreibrichtung **8** und der relativen Luftfeuchtigkeit der Atmosphäre **6** abhängt.

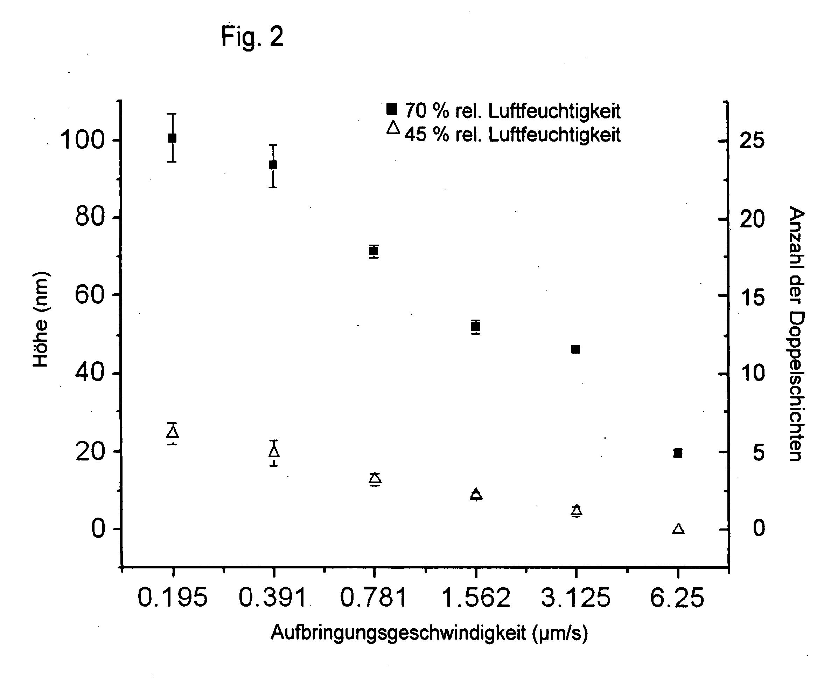

**Figur 2** zeigt links die Höhe von erfindungsgemäß hergestellten Phospholipidschichten und rechts die entsprechende Anzahl von Lipid-Doppelschichten als Funktion der Geschwindigkeit des Aufbringens der Schicht in Schreibrichtung **8** für verschiedene Werte der relativen Luftfeuchtigkeit (70 und 45 %). Die Höhe der Schichten **5, 5'** wurde mit einem AFM bestimmt; die Fehlerbalken geben die Standardabweichung an.

Aus **Figur 2** kann entnommen werden, dass die Dicke der Phospholipidschichten und damit die Anzahl der Lipid-Doppelschichten linear von der Geschwindigkeit des Aufbringens der Schicht **5, 5'** in Schreibrichtung **8** abhängt. Eine derartige lineare Abhängigkeit lässt sich auch bei der lateralen Diffusion, wie sie bei kovalenter DPN auftritt, beobachten. Hier liegt jedoch ein anderer Effekt vor, der die Herstellung von dreidimensionalen Strukturen aus Phospholipiden mit definierter Schichtdicke ermöglicht.

## Patentansprüche

1. Verfahren zum Aufbringen einer oder mehrerer, übereinander aufgebrachter Doppelschichten von Membranlipiden auf ein Substrat mit den Verfahrensschritten:
a) Bereitstellen des Substrats und eines Tintenvorrats mit einer Tinte aus Molekülen,
b) Eintauchen der Spitze eines Rasterkraftmikroskops in die Tinte aus den Molekülen, wodurch die Spitze des Rasterkraftmikroskops mit den Molekülen benetzt wird,
c) Inkontaktbringen der Spitze des Rasterkraftmikroskops mit der Oberfläche des Substrats, wobei die Oberfläche direkt berührt wird, und Bewegen der Spitze derart über Bereiche der Oberfläche, dass die Moleküle in diesen Bereichen von der Spitze des Rasterkraftmikroskops auf die Oberfläche des Substrats wandern und sich dort anordnen,
d) Entfernen der Spitze von der Oberfläche des Substrats, **dadurch gekennzeichnet, dass** der Tintenvorrat in Form einer Lösung eines Membranlipids in einem unpolaren Lösungsmittel bereitgestellt wird und die Lösung solange stehengelassen wird, bis das Lösungsmittel verdampft ist, bevor die Spitze des Rasterkraftmikroskops durch Eintauchen in den Tintenvorrat, der die Membranlipide enthält, mit den Membranlipiden benetzt wird, und sich die Membranlipide auf der Oberfläche des Substrats aus Silizium, Glas, Metall oder Polymer in Form von einer oder mehreren, übereinander aufgebrachten Lipid-Doppelschichten als flüssigkristalline Phase anordnen, wobei die Anzahl der Lipid-Doppelschichten auf der Oberfläche des Substrats über die Geschwindigkeit der Spitze des Rasterkraftmikroskops über der Oberfläche des Substrats und die relative Luftfeuchtigkeit von mindestens 40 % in der Atmosphäre eingestellt wird.

2. Verfahren nach Anspruch 1, **dadurch gekennzeichnet, dass** Chloroform oder Dichlormethan als unpolares Lösungsmittel eingesetzt wird.

3. Verfahren nach Anspruch 1 oder 2, **dadurch gekennzeichnet, dass** ein Farbstoff zur Lösung des Membranlipids im unpolaren Lösungsmittel hinzugefügt wird.

4. Verfahren nach einem der Ansprüche 1 bis 3, **dadurch gekennzeichnet, dass** ein Phospholipid als Membranlipid eingesetzt wird.

5. Verfahren nach Anspruch4, **dadurch gekennzeichnet, dass** 1,2-Dioleoyl-sn-Glycero-3-Phosphocholin (DOPC) oder 1,2-Dimyristoyl-sn-Glycero-3-Phosphocholin (DMPC) als Phospholipid eingesetzt wird.

6. Verfahren nach einem der Ansprüche 1 bis 5, **dadurch gekennzeichnet, dass** ein Membranlipid mit einer Fluoreszenzmarkierung versehen wird.

## Claims

1. A method for applying one or a plurality of mutually superposed bilayers of membrane lipids to a substrate, comprising the method steps:
a) providing a substrate and an ink reservoir having an ink made from molecules,
b) dipping the tip of an atomic force microscope into the ink made from the molecules so as to moisten the tip of the atomic force microscope with the molecules,
c) bringing the tip of the atomic force microscope into contact with the surface of the substrate, with the surface being directly touched, and moving the tip over regions of the surface so that the molecules in those regions migrate from the tip of the atomic force microscope to the surface of the substrate and arrange themselves there,
d) removing the tip from the surface of the substrate, wherein the ink reservoir is provided in the form of a solution of a membrane lipid in a nonpolar solvent and the solution is left to stand until the solvent has evaporated before the tip of the atomic force microscope is moistened with the membrane lipids by dipping into the ink reservoir containing the membrane lipids, and the membrane lipids arrange themselves on the surface of the substrate made from silicon, glass, metal or polymer in the form of one or a plurality of mutually superposed lipid bilayers as a liquid-crystalline phase, the number of lipid bilayers on the surface of the substrate being controlled by the velocity of the tip of the atomic force microscope over the surface of the substrate and the relative air humidity of at least 40 % in the atmosphere.

2. The method according to claim 1 wherein chloroform or dichloromethane is used as nonpolar solvent.

3. The method according to claim 1 or 2 wherein a dye is added to the solution of the membrane lipid in the nonpolar solvent.

4. The method according to any one of claims 1 to 3 wherein a phospholipid is used as membrane lipid.

5. The method according to claim 4 wherein 1,2-dioleoyl-sn-glycero-3-phosphocholin (DOPC) or 1,2-dimyristoyl-sn-glycero-3-phosphocholin (DMPC) is used as phospholipid.

6. The method according to any one of claims 1 to 5 wherein a membrane lipid is provided with a fluorescence marking.

## Revendications

1. Procédé d'application, d'une ou de plusieurs doubles couches appliquées les unes sur les autres de lipides membranaires, sur un substrat comportant les étapes suivantes :
a) obtention du substrat et d'une réserve d'encre avec une encre moléculaire,
b) immersion de la pointe d'un microscope à force atomique à balayage dans l'encre moléculaire, de sorte que la pointe du microscope à force atomique soit mouillée par les molécules.
c) mise en contact de la pointe du microscope à force atomique avec la surface du substrat, cette surface étant directement touchée, et déplacement de la pointe sur des zones de la surface de sorte que dans ces zones, les molécules migrent de la pointe du microscope à force atomique sur la surface du substrat, et s'y ordonnent,
d) éloignement de la pointe de la surface du substrat,
**caractérisé en ce que**
la réserve d'encre est fournie sous la forme d'une solution d'un lipide membranaire dans un solvant non polaire, et cette solution est laissée au repos jusqu'à ce que le solvant soit évaporé avant que la pointe du microscope à force atomique soit mouillée par les lipides membranaires par immersion dans la réserve d'encre qui renferme les lipides membranaires, et que les lipides membranaires s'ordonnent en tant que phase de cristaux liquides, sur la surface du substrat en silicium, verre, métal ou polymère sous la forme d'une ou de plusieurs doubles couches lipidiques appliquées les unes sur les autres, le nombre de doubles couches lipidiques sur la surface du substrat étant réglé par la vitesse de balayage de la pointe du microscope à force atomique sur la surface du substrat, et l'humidité relative de l'air atmosphérique étant réglée à au moins 40 %.

2. Procédé conforme à la revendication 1,
**caractérisé en ce qu'**
on utilise du chloroforme ou du dichlorométhane en tant que solvant non polaire.

3. Procédé conforme à la revendication 1 ou 2,
**caractérisé en ce qu'**
on ajoute un colorant à la solution du lipide membranaire dans le solvant non polaire.

4. Procédé conforme à l'une des revendications 1 à 3,
**caractérisé en ce qu'**
on utilise un phospholipide en tant que lipide membranaire.

5. Procédé conforme à la revendication 4,
**caractérisé en ce qu'**
en tant que phospholipide, on utilise de la 1,2-dioleoyl-sn-glycéro-3-phosphocholine (DOPC) ou de la 1,2-dimyristoyl-sn-glycéro-3-phosphocholine (DMPC).

6. Procédé conforme à l'une des revendications 1 à 5,
**caractérisé en ce qu'**
on met en oeuvre un lipide membranaire marqué par fluorescence.
